# EUROPÄISCHE PATENTSCHRIFT

(11) **EP 3 171 191 B1**
(45) Veröffentlichungstag und Bekanntmachung des Hinweises auf die Patenterteilung: **02.05.2018**
(21) Anmeldenummer: 16199138.5
(22) Anmeldetag: 16.11.2016
(51) Int. Cl.: G01R 33/30

(54) **WINKELVERSTELLBARER MESSKOPF EINER NMR-MAS-APPARATUR**
VARIABLE ANGLE MEASURING HEAD OF AN NMR MAS APPARATUS
SONDE À ANGLE RÉGLABLE D'UN APPAREIL RMN AVEC ROTATION A L'ANGLE MAGIQUE

(30) Priorität: 20.11.2015 DE 102015222935
(43) Veröffentlichungstag der Anmeldung: 24.05.2017
(73) Patentinhaber: Bruker BioSpin AG, 8117 Fällanden (CH)
(72) Erfinder: Freytag, Nicolas, 8122 Binz (CH); Kühler, Fabian, 8603 Schwerzenbach (CH)
(74) Vertreter: Kohler Schmid Möbus Patentanwälte

(56) Entgegenhaltungen:
- US-A1- 2006 152 221
- US-A1- 2011 018 536

## Beschreibung

Die Erfindung betrifft einen Messkopf einer NMR (=Kernspinresonanz)-MAS (=magic angle spinning) Apparatur, der im Betrieb zumindest zum Teil in einen Hohlraum eines Magnetsystems eingeführt ist, das ein homogenes statisches Magnetfeld ***B***₀ in einer z-Richtung erzeugt, wobei sich im Betrieb der NMR-MAS-Apparatur im Messkopf eine Messprobe befindet, die eine Rotationsachse aufweist, wobei die Rotationsachse in Bezug auf die z-Achse um einen Winkel *θ* > 0 geneigt ist, in einer xz-Ebene liegt, und wobei der Winkel *θ* durch eine mechanische Drehung um eine Drehachse parallel zur *y*-Achse im Intervall *θ*ₛₒₗₗ -α1 ≤ *θ* ≤ *θ*ₛₒₗₗ + α2 um einen Zielwinkel *θ*ₛₒₗₗ herum mit den Verstellwinkeln α1, α2 verstellt werden kann, und wobei *z* = 0 als der Schnittpunkt der Rotationsachse mit der z-Achse bei eingestelltem Winkel *θ* = *θ*ₛₒₗₗ definiert ist.

Ein solcher NMR-MAS Messkopf ist etwa bekannt aus US 7,498,812 B2.

### Hintergrund der Erfindung

NMR-Spektroskopie ist ein Verfahren der instrumentellen Analytik, mit dem insbesondere die chemische Zusammensetzung von Messproben bestimmt werden kann. Dabei werden Hochfrequenz-Pulse in die Messprobe, die sich in einem starken, homogenen statischen Magnetfeld ***B***₀ befindet, eingestrahlt, und die elektromagnetische Reaktion der Probe wird vermessen. Bei der Festkörper NMR-Spektroskopie ist es bekannt, zur Verringerung von Linienverbreiterungen aufgrund anisotroper Wechselwirkungen die Messprobe in einer Ausrichtung zum homogenen statischen Magnetfeld anzuordnen, die statt der herkömmlichen 0° oder 90° unter dem sogenannten "magischen Winkel" von *θ*ₘ = arccos(√⅓) ≈ 54,74° geneigt ist. Diese Messtechnik wird üblicherweise als "magic-angle spinning" (MAS) bezeichnet. Der Winkel *θ*ₘ ist eine Lösung des zweite-Ordnung Legendrepolynoms *P*₂(cos(*θ*ₘ)) = 0, so dass alle Wechselwirkungen die von diesem Legendrepolynoms abhängen unter diesem Winkel zum Magnetfeld verschwinden. Dies ist der Fall für drei wichtige Wechselwirkungen in der Materie: der dipolaren Kopplung, der chemischen Shift Anisotropie und der Quadrupolwechselwirkung erster Ordnung. Da für nicht einkristalline Messproben die Kristallrichtungen einzelner Kristallite zufällig zum statischen Feld stehen wird die Auslöschung der Wechselwirkung durch eine ausreichend schnelle Rotation der Messprobe im magischen Winkel erzielt. Somit lässt sich eine Linienverbreiterung durch diese Wechselwirkungen signifikant reduzieren, im Idealfall sogar bis zur natürlichen Linienbreite.

MAS-NMR-Messköpfe erlauben es hochauflösende NMR Spektroskopie mit festen, pulverförmigen oder semisoliden (gelförmigen oder pastösen) Messproben durchzuführen. Dabei wird die Messprobe in einen kreiszylinderförmigen Probenbehälter, den sogenannten Rotor gefüllt, der mittels komprimierter Gase in einem Stator zu sehr hohen Drehzahlen mit einer Rotationsfrequenz im Bereich einiger kHz bis über hunderttausend kHz rotiert wird. Die radiale Lagerung wird durch Luftlager im Stator sichergestellt ebenso wie eine durch Luftströmung erzeugte Haltekraft den Rotor in seiner axialen Position im Stator hält.

### Stand der Technik

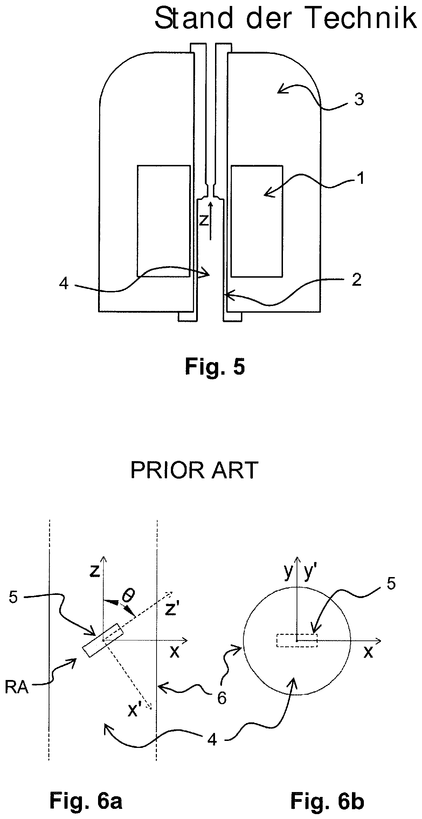

In der Regel werden diese Messköpfe in supraleitenden NMR Magnetsystemen eingesetzt, bei denen das homogene statische Magnetfeld ***B***₀ entlang einer "Bohrung" orientiert ist, die die z-Achse des Laborkoordinatensystems vorgibt. Ein solches Magnetsystem ist in Fig. 5. dargestellt. Das Magnetsystem besteht in der Regel aus einem Magneten, und mindestens einem Shimsystem. Der Magnet besteht üblicherweise aus einer Vakuumisolation/Dewar, Strahlungsschilden, mindestens einer Magnetspule und Sicherheitselementen. Die Magnetspule ist in der Regel so ausgelegt, dass sie nach außen aktiv abgeschirmt ist um einen möglichst geringen Einfluss von Suszeptibilitätsänderungen in der direkten Umgebung des Magneten auf dessen Feld sicherzustellen. Das Shimsystem ist häufig zweiteilig ausgeführt und besteht aus einem aus supraleitendem Draht hergestellten, kryogen gekühlten Teil innerhalb des Dewars und einem Raumtemperatur-Shimsystem, das innerhalb der Bohrung des Dewars angeordnet ist. Das Magnetsystem weist einen Hohlraum auf, in den der NMR Messkopf während einer Messung eingeführt wird. Dieser Hohlraum ist in der Regel weitestgehend abschnittsweise rohrförmig, kann aber auch konusförmige Abschnitte enthalten, die als Zentrierungen für Messköpfe, Messproben, etc dienen.

In Figuren 6a und 6b ist die Messprobe 5, die Rotationsachse RA und die Wandung des Hohlraumes 6 in zwei orthogonalen Schnitten dargestellt. Weitere Elemente des NMR Messkopfes wie HF-Spulen, Stator, Wandungen, Netzwerke etc sind der Einfachheit halber nicht dargestellt. Die Rotationsachse RA der Messprobe wird auch als *z'*-Achse bezeichnet und hat einen gemeinsamen Ursprung mit der *z*-Achse. Die *z*- und *z*'-Achsen liegen in einer Ebene, die durch die *x*- und *z*-Achsen sowie die *x'*- und *z*'- Achsen aufgespannt wird. Die *y*- und *y*'-Achsen der beiden Koordinatensysteme sind identisch.

Für viele NMR Experimente in Magnetsystemen mit ***B***₀-Feldern im Bereich von 7 T bis 25 T ist eine Präzision der Einstellung des magischen Winkels von 0.1° bis 0.01° ausreichend, für einige Anwendungen wie z.B. satellite transition (STMAS) NMR wird jedoch eine Präzision von bis zu 0.001° gefordert. Die Winkeleinstellung muss über einen weiten Temperaturbereich konstant bleiben sowie beim Wechsel der Messproben reproduzierbar gewährleistet sein.

Bei den meisten MAS-Messköpfen nach dem Stand der Technik wird die Verstellung des Winkels durch einen im Messkopf integrierten Mechanismus realisiert (siehe etwa die eingangs zitierte US 7,498,812 B2 oder beispielsweise auch US 2014/0099730 A1, US 7,535,224 B2, US-A 5,260,657), wie schematisch in der Fig. 8 dargestellt. Dabei sind verschiedene Verfahren gängig, die Seilzüge mit Anschlägen, Stangen und Hebel, Zahnräder, Spindeln etc verwenden. Diese Verfahren sind auch bei hermetisch geschlossenen Messköpfen im Einsatz, bei denen sich z.B. die Temperaturen von Messprobe und Detektionsspule wesentlich unterscheiden, und werden dort mittels Balgen oder O-Ring-Dichtungen realisiert (siehe etwa in US 7,282,919 B2).

Eine technologische Herausforderung der im Messkopf integrierten Winkelverstellung sind die extrem hohen Anforderungen an die Präzision und Reproduzierbarkeit des Mechanismus. Geht man von typischen Hebellängen im Bereich von ca. 2 cm bis 3 cm aus, resultiert aus der geforderten Winkelpräzision eine mechanische Toleranz von ca. 0.5 µm bis 5 µm. Derart enge Toleranzen führen zu hohen Herstellungskosten für die mechanischen Komponenten.

MAS-Messköpfe weisen typischerweise in einen sehr weiten Temperierbereich für die Messproben auf. Am unteren Ende der Temperierskala finden sich Messköpfe, die bis -50 °C, -80 °C, -130 °C oder sogar für Temperaturen im kryogenen Bereich von 30 K bis 100 K spezifiziert sind. Bei den oberen Grenzwerten der Temperierung sind Temperaturen bis +80 °C, +150 °C oder im Falle von Spezialproben sogar weit darüber hinaus spezifiziert. Die Temperierung der Messproben wird in den meisten Fällen durch Temperiergas sichergestellt, wobei unter anderem auch die Luft der Lager und/oder die Antriebsluft temperiert wird.

Aufgrund der Kompaktheit der Konstruktion (die Messprobendurchmesser sind typischerweise im Bereich von 0.7 mm bis 4 mm) ist die Temperatur zumindest eines Teils des Kippmechanismus nahe an der Temperatur der Messproben. Die Wiederholbarkeit der Einstellung eines Winkels mit hoher Präzision und über einen weiten Temperaturbereich hinweg ist technisch extrem schwierig zu realisieren und führt zu hohen Kosten in der Herstellung der mechanischen Teile.

Weiterhin ist aus der US 8,547,099 B2 ein NMR System mit einem Messkopf ohne internen Verstellmechanismus bekannt. Bei diesem NMR-System wird die Neigung der Rotationsachse (*z'*-Achse) gegenüber dem Messkopf und dem Magnetsystem konstant gehalten und die Richtung des statischen Magnetfeldes dadurch gedreht, dass mittels einer zusätzlichen elektromagnetischen Spule, die um die Messprobe herum angeordnet ist, ein Feld ***B***₁ erzeugt wird, so dass der Winkel zwischen der z'-Achse und der Richtung der Linearkombination der ***B***₀ und ***B***₁ Felder dem magischen Winkel entspricht.

Obwohl dieses Verfahren die schnelle und präzise Einstellung des Winkels ermöglicht ist ein großer Nachteil, dass zum Einbringen der zusätzlichen elektromagnetischen Spule in das Magnetsystems der Durchmesser des Messkopfes im Bereich der Messprobe reduziert werden muss. Weiterhin ist der Verstellbereich durch die in der zusätzlichen Spule generierte Dissipation im Betrieb auf sehr kleine Winkelkorrekturen im Bereich von weniger als 0.05° begrenzt (siehe Referenz [8]).

Die Reduktion des Außendurchmessers in Bezug auf einen Messkopf mit internem Verstellmechanismus weist diverse Nachteile auf:
1. Der für die technische Realisierung der Messprobenrotation (Luftlager, Antrieb, Gasleitungen etc.) verfügbare Platz sinkt. Dies erhöht die Komplexität und generiert zusätzliche Kosten.
2. Der für die HF-Felder verfügbare Platz innerhalb einer elektrischen Abschirmung sinkt so dass die HF-Performanz der Messköpfe reduziert wird. Dies drückt sich in reduziertem Signal zu Rauschverhältnis der Messung aber auch erhöhtem Leistungsbedarf zum Erreichen der Pulsdauern und damit einhergehender höherer Dissipation im Betrieb aus.
3. Der verfügbare Platz für Gasleitungen, HF-Netzwerk und eventuell Wärmetauschern, Pumpleitungen und verstellbaren HF-Elementen sinkt. Dies kann die Leistungsfähigkeit diverser Komponenten des Messkopfes negativ beeinflussen.

Aus diesen Gründen muss die Reduktion des Durchmessers eines Messkopfes zumindest im zentralen Bereich möglichst klein ausfallen.

Auf dem Markt existieren zwei Typen von Magnetsystemen: sogenannte standard bore (="SB") Magnetsysteme und wide bore (="WB") Magnetsysteme, deren Bohrungen einen Durchmesser *D*_{B} im Bereich von ungefähr *D*_{B} = 40 mm +/- 2 mm für SB und *D*_{B} = 73 mm +/- 2 mm für WB Systeme liegen.

Für SB Magnetsysteme sind Durchmesserreduktionen von mehr als 10 mm für die Leistungsfähigkeit der Messproben nicht mehr tolerierbar, für viele Anwendungen sind bereits 5 mm schädlich. Da in diesem reduzierten Volumen keine ausreichend leistungsfähigen zusätzlichen elektromagnetischen Spulen zur Winkelkorrektur herstellbar sind, ist eine rein elektrische Einstellung des magischen Winkels für SB-Messköpfe, insbesondere für die Höchstfeld-NMR mit Magnetfeldstäken *B*₀ > 20 T nicht realistisch.

### Aufgabe der Erfindung

Der vorliegenden Erfindung liegt demgegenüber die Aufgabe zugrunde, einen NMR-MAS-Messkopf der eingangs definierten Art zur Verfügung zu stellen, der es erlaubt, kostengünstig und mit einfachen, ohne Weiteres zur Verfügung stehenden technischen Mitteln den Winkel *θ* über einen möglichst großen Bereich mit hoher Präzision und Reproduzierbarkeit zu verstellen, ohne hierbei wesentliche Einbußen in der Performanz des Messkopfes hinnehmen zu müssen.

### Beschreibung der Erfindung

Diese Aufgabe wird auf ebenso überraschend einfache wie wirkungsvolle Weise sowie mit ohne Weiteres zur Verfügung stehenden technischen Mitteln dadurch gelöst, dass bei einem NMR-MAS-Messkopf der eingangs genannten Art die Rotationsachse gegenüber dem Messkopf eine unveränderliche feste Winkellage aufweist, dass vorgesehen ist, mittels eines Verstellmechanismus der NMR-MAS-Apparatur zumindest den in den Hohlraum eingeführten Teil des Messkopfs bei der mechanischen Drehung um die Drehachse um einen Winkel α mit -α1 ≤ α ≤ α2 gegenüber der *z*-Achse zu verstellen, dass der Hohlraum des Magnetsystems ein ausgedehnter Körper ist, der durch eine Menge *M* von Raumpunkten beschrieben wird, wobei eine Menge *N* aus allen Teilmengen *O*(α) besteht und die Teilmengen *O*(α) durch Drehung um den Winkel α mit -α1 ≤ α ≤ α2 um die Drehachse aus der Menge *M* entstandene Körper beschreiben, dass eine Menge *P* = ∩*N* die Schnittmenge aller durch Drehung um einen Winkel α mit -α1 ≤ α ≤ α2 aus dem Hohlraum des Magnetsystems generierter Körper ist, dass der Messkopf eine äußere Kontur *K* hat, die ein oberes Ende bei *z* = *L*1 und ein unteres Ende bei *z* = -*L*2 aufweist und für die gilt, dass K eine Teilmenge von *P* ist: *K* □ *P*, wobei für alle *z* mit *-L2* ≤ *z* ≤ *L*1 ein Schnitt *S*(*z*) der Kontur K parallel zur *xy-*Ebene existiert, und wobei der Schnitt *S*(0) eine Ausdehnung *Q*(0) in der *x-*Richtung aufweist,
dass mindestens ein Schnitt *S*(*z*1) mit *z*1 < 0 existiert mit einer Ausdehnung *Q*(*z*1) in der *x*-Richtung, wobei *Q*(*z*1) < *Q*(0), und dass mindestens ein Schnitt *S*(*z*2) mit *z*2 > 0 existiert mit einer Ausdehnung *Q*(z2) in der *x*-Richtung wobei *Q*(z2) < *Q*(0).

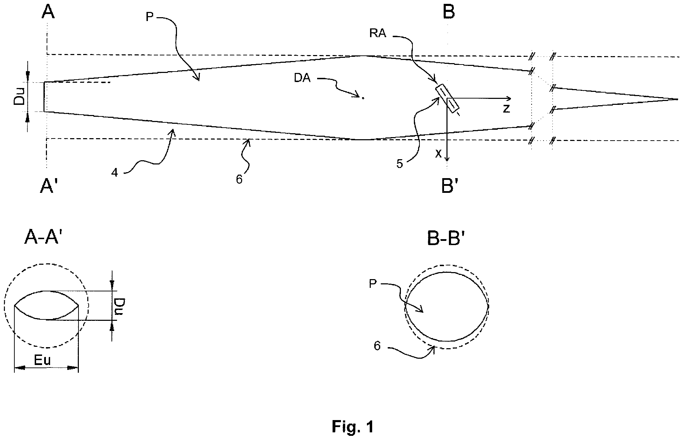

Fig. 1 zeigt einen Fall, bei dem der Hohlraum 4 des Magnetsystems aus einer durchgehenden kreiszylinderförmigen Bohrung besteht und der Schnitt mit der *xz*-Ebene dargestellt ist. Die Schnitte A-A' und B-B' sind parallel zur *xy*-Ebene. Die Begrenzung des Hohlraumes ist in Fig. 1 mit gestrichelten Linien dargestellt, wohingegen die Begrenzung der Menge *P* mit durchgezogenen Linien dargestellt ist. Ebenfalls dargestellt ist die Messprobe 5 und die Rotationsachse RA, deren Schnittpunkt mit der z-Achse den Nullpunkt des Koordinatensystems definiert und die Drehachse DA. In diesem konkreten Fall sind die maximalen negativen und positiven Verstellwinkel identisch: α1 = α2.

Mit der vorliegenden Erfindung wird also ein Messkopf für die NMR-MAS-Spektroskopie bereitgestellt, der es ermöglicht den Winkel der Rotationsachse einer Messprobe mit hoher Präzision und Reproduzierbarkeit gegenüber dem statischen homogenen Magnetfeld ***B***₀ zu verstellen und zugleich ein möglichst großes Volumen innerhalb des Messkopfes zur technischen Realisierung der elektromagnetischen, pneumatischen und mechanischen Komponenten zur Verfügung stellt.

Eine vom Stand der Technik abweichende Möglichkeit die Anforderungen an hohe Präzision und Reproduzierbarkeit der Winkeleinstellung zu gewährleisten ist es den Verstellmechanismus anstelle im Messkopf selbst außerhalb des Messkopfs zu verlegen und den Messkopf in seiner Gesamtheit, zumindest jedoch den in die Magnetbohrung (i.e. den Hohlraum des Magnetsystems) eingeführten Teil des Messkopfs gegenüber dem statischen Feld ***B***₀ zu verkippen. Durch das Verstellen des Messkopfes können die Dimensionen der Mechanik für die Winkelverstellung viel größer ausfallen als für den Fall eines internen Mechanismus. Die Hebelverhältnisse werden vorteilhafter und die Kosten für Mechanik mit ausreichender Präzision sinken in der Folge deutlich. Typischerweise können sich die Abstände zwischen der Drehachse und einem Angriffspunkt für die Verstellmechanik außerhalb der Bohrung des Magnetsystems im Bereich von einem halben bis einem Meter bewegen, so dass die Anforderungen an die Präzision der Verstellmechanik nunmehr lediglich ca. 10 - 200 µm betragen. Weiterhin kann die Hülle des Messkopfes und außerhalb des Messkopfes liegende Komponenten deutlich besser gehen eine Veränderung der Temperatur der Messproben isoliert werden, so dass die Anforderungen an eine Temperaturkompensation der Verstellmechanik ebenfalls sinken.

Für besonders hohe Anforderungen an Präzision und Reproduzierbarkeit kann eine Regelung der Temperaturen innerhalb des Hohlraumes des Magnetsystems und/oder der das NMR System umgebenden Raumluft vorgesehen werden. Eine solche Regelung in Kombination mit einer guten Isolation der Messprobe und zur MAS-Operation notwendigen Gasströme gegenüber dem Messkopfmantel minimiert die Anforderungen an thermische Ausdehnungskoeffizienten der verwendeten Materialien. Weiterhin ist die Verwendung von Sensoren zur Einstellung des Winkels im Stande der Technik bekannt, wobei die Sensoren auf Hall-Sensoren (siehe Referenzen [7, 9]), optischen Sensoren (Referenz [10]) und/oder Neigungssensoren basieren.

Im Stand der Technik weisen Messköpfe in der Regel eine kreiszylinderförmige Außenkontur auf. Diese lässt sich besonders kostengünstig aus einem Rohr fertigen. Wird die Verstellung des Winkels *θ* nun durch eine Drehung des Messkopfes gegenüber dem Magnetsystem erzielt, so muss bei Messköpfen mit konstantem Außendurchmesser dieser so weit reduziert werden, dass der notwendige Rotationsbereich für die Messprobe ohne Kollision mit der Bohrung des Magnetsystems erzielbar ist. Die geringste Reduktion ist für den Fall eines Drehpunktes auf halber Länge zwischen dem unteren Ende des Magnetsystemrohres und dem oberen Ende des Messkopfes erreicht. Nachteilig an dieser Anordnung ist, dass der Drehpunkt sich nicht bei *z* = 0 befindet und sich die Messprobe bei einer Korrektur des Kippwinkels lateral (i.e. in x-Richtung) aber auch axial (i.e. in z-Richtung) in Bezug auf den Magneten bewegt. Dadurch können Shimkorrekturen notwendig werden um die erforderliche Feldhomogenität in der Messprobe wiederherzustellen. Weiterhin kann die Messprobe zumindest an einem der beiden Enden aus dem homogensten Bereich eines Magneten geschwenkt werden so dass die erzielbaren NMR Linienbreiten verschlechtert werden.

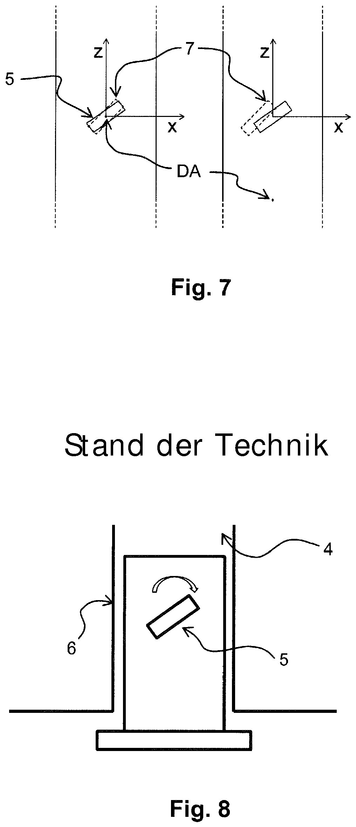

Dies ist in Figur 7 dargestellt: Die Messprobe 5 ist in ihrer ursprünglichen Position jeweils durchgezogen, die gedrehte Messprobe 7 ist mit gestrichelten Linien dargestellt. Bei einer Drehung um die Drehachse DA um einen Winkel α wird die Messprobe für den Fall des Drehpunktes bei *z* = 0 (Fig. 7, links) in *x*- und *z*-Richtung kaum verschoben, wohingegen für den Fall des Drehpunktes bei *z ≠* 0 (Fig. 7, rechts) ein Verschwenken der Messprobe aus der Mittelposition einhergeht, der zu einer Bewegung des Schwerpunktes der Messprobe in *x*- und *z*-Richtung führt.

Wird der Drehpunkt jedoch im Zentrum der Messprobe angeordnet um obengenannten Probleme zu umgehen, so reduziert sich der mögliche Außendurchmesser des Messkopfmantels signifikant, da die Ausdehnung des Messkopfes oberhalb des Nullpunktes *L*1 in der Regel deutlich kleiner ist als die Ausdehnung -*L*2 unterhalb des Nullpunktes des Koordinatensystems.

Typischerweise wird eine Verstellbarkeit des Winkels von +/- 1°, zumindest jedoch von +/- 0.5° gefordert, was sich bei einer Distanz zwischen Drehachse DA und dem oberen oder unteren Ende des Messkopfes von 0.5 m bis 1 m zu einer lateralen Auslenkung des Messkopfes im Bereich von 4.5 mm bis 17.5 mm und damit einer Reduktion des Außendurchmessers von 9 mm bis 35 mm führt.

Während bei einem SB-System der Außendurchmesser im besten Fall bereits um über ein Fünftel (theoretisch bis zu neun Zehntel) reduziert werden müsste, kann die Reduktion bei einem WB-System im Bereich von einem Zehntel bis einem Viertel des Außendurchmessers liegen. Daraus wird ersichtlich, dass die oben zitierten technischen Nachteile, die durch einen global reduzierten Außendurchmesser zustande kommen, lediglich für WB-Systeme oder sehr kompakte (kurze) SB-Systeme mit geringen Anforderungen an den erzielbaren Verstellbereich tolerierbar sind, insbesondere für SB Systeme mit Magnetsystemen hoher Feldstärke, die in der Regel deutlich weniger kompakt ausfallen, jedoch zu inakzeptablen Leistungseinbußen der Messköpfe führen würden.

### DEFINITIONEN:

Das Magnetsystem besteht aus mindestens einem Magneten und mindestens einem Shimsystem und erzeugt ein homogenes statisches Magnetfeld ***B***₀ das parallel zu einer *z*-Achse ist. Das Magnetsystem weist in der Regel einen zumindest in einem zentralen Abschnitt im Wesentlichen zylinderförmigen Hohlraum 4 mit einer Zylinderachse auf, die mit der *z*-Achse eines Koordinatensystems zusammenfällt. Der Hohlraum hat mindestens eine Öffnung, die zum Einführen eines Messkopfes in das Magnetsystem dient. Diese Öffnung soll sich gemäß Definition unabhängig von der Polarität des Magnetfeldes *B*₀ an einem unteren Ende (*z* < 0) des Magnetsystems befinden. Der Hohlraum kann in der Regel abschnittsweise durch Zylinder-, Konus- und Kugelabschnitte sowie Segmente angenähert werden. Unter Abschnitt soll ein Teilstück des Ganzen verstanden werden: abschnittsweise kreiszylinderförmig beinhaltet beliebige Teilstücke eines Kreiszylinders. Insbesondere Abschnitte entlang der *z*-Achse, deren Schnitte mit der *xy*-Ebene kreisförmig sind.

Der Messkopf ist dafür vorgesehen eine Messprobe in einem kreiszylinderförmigen Probenbehälter aufzunehmen. Der Probenbehälter weist somit eine Achse auf, die als Rotationsachse RA bezeichnet wird. Der Messkopf ist mit den technischen Mitteln ausgestattet (Lager und Antrieb) um den Probenbehälter um seine Rotationsachse rotieren zu lassen. Diese Rotation erreicht Frequenzen größer als 1 kHz, insbesondere größer als 10 kHz und im Idealfall Rotationsfrequenzen die so gestaltet sind, dass die Geschwindigkeit *v* der Rotoroberfläche im Bereich 0.7 *v*_{Schall} *< v < v*_{Schall} liegen, wobei *v*_{Schall} die Schallgeschwindigkeit des den Rotor umgebenden Mediums bei den in der Umgebung des Rotors herrschenden Bedingungen (Druck, Temperatur, ...) ist. Dieses Medium ist idealerweise ein Gas, vorzugsweise Luft, Stickstoff oder Helium mit einem Druck im Bereich von 10⁻⁴hPa bis 10⁴hPa.

Die Rotationsachse des Probenbehälters ist in Bezug auf die *z*-Achse um einen Winkel *θ* > 0 geneigt und liegt in der *xz*-Ebene. Der Messkopf und/oder das NMR System bestehend aus dem Magnetsystem, dem Messkopf und einer Messkopfhalterung beinhalten eine Vorrichtung, die dazu dient die Messprobe auf einen Sollwinkel *θ*ₛₒₗₗ in Bezug auf die z-Achse auszurichten. Diese Vorrichtung definiert eine Drehachse DA, die weitestgehend parallel zur *y-*Achse liegt. Der Schnittpunkt der Rotationsachse der Messprobe mit der *z-*Achse bei eingestelltem Winkel *θ*ₛₒₗₗ definiert *z* = 0.

Der Schnittpunkt der Drehachse mit der *xz*-Ebene kann bei *x,z* = 0 liegen, im Allgemeinen jedoch positive oder negative Werte annehmen.

Die Drehachse der Kippbewegung schneidet idealerweise die Rotationsachse in einem zentralen Bereich der Messprobe. Alternativ kann die Kippachse die die *xz*-Ebene bei *x* ≠ 0 oder *z* ≠ 0 schneiden.

Das NMR System erlaubt die Veränderung des Winkels *θ* im Intervall *θ*ₛₒₗₗ - α1 ≤ *θ* ≤ *θ*ₛₒₗₗ + α2. Die maximalen negativen und positiven Verstellwinkel α1 und α2 können identisch sein, sind im Allgemeinen jedoch verschieden. Es ist auch möglich, dass einer der beiden Verstellwinkel αi = 0 ist.

Der Hohlraum des Magnetsystems, in den der Messkopf im Betrieb eingeführt wird, weist ein unteres Ende bei *z* = -*L*2 auf. Im Betrieb und bei ausgerichtetem Winkel *θ* = *θ*ₛₒₗₗ befindet sich das obere Ende des Messkopfes bei *z* = *L*1.

Der Hohlraum des Magnetsystems ist ein ausgedehnter Körper, der durch eine Menge *M* von Raumpunkten beschrieben wird. Die Menge *M* enthält alle Raumpunkte, die im Hohlraum des Magnetsystems enthalten sind.

Der Körper beschrieben durch die Menge *M* kann um einen Verstellwinkel α mit α1 ≤ α ≤ α2 um die Drehachse rotiert werden. Die resultierenden Körper werden durch die Mengen *O*(α) beschrieben.

Die Menge *N* besteht aus allen Teilmengen *O*(α), i.e. aus allen durch Drehung um den Winkel α mit -α1 ≤ α ≤ α2 um die Drehachse aus der Menge *M* entstandenen Körpern. Die Schnittmenge *P* = ∩*N* aller durch Drehung um einen Winkel α mit -α1 ≤ α ≤ α2 aus dem Hohlraum des Magnetsystems generierter Körper beschreibt den für eine Drehung des Messkopfes um die Winkel α mit -α1 ≤ α ≤ α2 ohne Kollision mit dem Magnetsystem maximal möglichen Körper.

Der Messkopf hat eine äußere Kontur *K*, die ein oberes Ende bei *z* = *L*1 und ein unteres Ende bei *z* = -*L*2 aufweist. Bestandteile des Messkopfes, die sich im Betrieb außerhalb des Hohlraumes befinden sollen nicht durch die Kontur *K* beschrieben sein. D.h. die Kontur *K* ist lediglich eine Teilmenge des Oberfläche des Messkopfs. Weiterhin gilt, dass *Keine* Teilmenge von *P* ist: *K* ⊂ *P*, insbesondere eine echte Teilmenge von *P* ist.

Für alle *z* mit -*L*2 ≤ *z* ≤ *L*1 existiert ein Schnitt *S*(*z*) der Kontur K parallel zur *xy-*Ebene. Dieser Schnitt hat eine Ausdehnung in der *x*-Richtung, die mit *Q*(*z*) und eine Ausdehnung in der *y*-Richtung, die mit *R*(*z*) bezeichnet werden.

### Bevorzugte Ausführungsformen und Weiterbildungen der Erfindung

Bei besonders bevorzugten Ausführungsformen des erfindungsgemäßen Messkopfes, bei welchen die Vorteile der vorliegenden Erfindung sich ganz besonders bemerkbar machen, nimmt der Winkel *θ*ₛₒₗₗ den Wert des magischen Winkels *θ*ₛₒₗₗ = arccos (3^{-0.5}) = *θ*ₘ in Bezug auf die z-Achse an. Dabei ist es von besonderem Vorteil, wenn eine Verstellung des Winkels über einen Winkel *θ*ₘ - α1 ≤ *θ* ≤ *θ*ₘ + α2 mit einer Präzision und Reproduzierbarkeit von 0.025°, besser 0.01°, idealerweise sogar 0.001° und 0° ≤ α1,2 ≤ 2°, wenigstens ≤ 1°, zumindest jedoch ≤ 0.5° ist. Ein solcher Messkopf kann für Applikationen der magic angle spinning NMR eingesetzt werden.

In der Praxis erweisen sich Ausführungsformen der Erfindung als besonders nützlich, bei welchen die Kontur K des Messkopfes abschnittsweise Zylindermantelförmig, insbesondere abschnittsweise Kreiszylindermantelförmig ist. Dies ist mechanisch besonders einfach zu lösen, da die Zylinderabschnitte aus gezogenen Profilen, Rohren oder Drehteilen hergestellt werden können. Insbesondere bevorzugt ist eine Ausführungsform, bei der mindestens einer der Zylindermantelabschnitte Kreiszylinderförmig ist, da dies die Herstellbarkeit weiter vereinfacht. Ganz besonders vorteilhaft sind Kreiszylinderförmige Abschnitte, die so gestaltet sind, das jeder Schnitt mit der *xy*-Ebene weitestgehend kreisförmig ist. Derart gestaltete Abschnitte lassen sich aus lediglich abgelängten Rohrstücken ohne Umformungen herstellen. Bei kreisförmigen Querschnitten kann z.B. besonders einfach eine Dichtung durch O-Ringe erzielt werden oder eine verschraubbare Verbindung hergestellt werden. Weiterhin ist ein Messkopf bevorzugt, dessen Kontur im Wesentlichen aus vier, besser drei und im Idealfall nur zwei Zylindermantelabschnitten besteht. Diese Ausführungsformen vereinfachen den Aufbau wesentlich und reduzieren die Kosten.

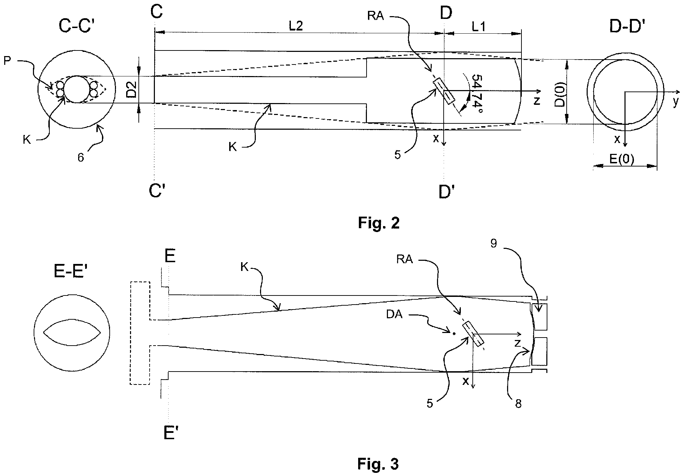

Fig. 2 stellt einen Messkopf gemäß dieser Ausführungsform dar. Die Kontur *K* des Messkopfes und die Begrenzung des Hohlraumes 4 sind als durchgezogene Linien dargestellt, wohingegen die Begrenzung der Menge *P* mit gestrichelter Linie dargestellt ist. Im Bereich der Messprobe besteht die Kontur aus einer Mantelfläche eines Kreiszylinders mit Durchmesser *D*(0) = *E*(0). In dieser konkreten Ausführungsform ist dieser Bereich symmetrisch zur Drehachse und zu *z* = 0 herum ausgeführt. Im Allgemeinen muss dies weder für die Drehachse noch für den Ursprung des Koordinatensystems gelten. In einem unteren Bereich ist die Kontur des Messkopfs aus einer Vielzahl von Kreiszylindermantelflächen zusammengesetzt. Der zentrale Kreiszylinder mit Durchmesser D2 kann hierbei als tragendes Element dienen wohingegen die kleineren Kreiszylinder Rohrleitungen für Gase und Kabel darstellen können.

Des Weiteren ist bei bevorzugten Ausführungsformen des erfindungsgemäßen Messkopfes die Kontur *K* des Messkopfes derart gestaltet, dass ein Schnitt *T* mit der *xz*-Ebene zumindest für einen Abschnitt eine Gerade unter dem Winkel +α1, -α1, +α2 oder -α2 aufweist. Diese Ausführungsformen bergen die Möglichkeit, ein maximales Volumen für den Messkopf zuzulassen.

Bevorzugt sind auch Ausführungsformen der Erfindung, bei denen die Kontur *K* zumindest für einen Abschnitt dergestalt ist, dass sich für den Schnitt *T* alle Punkte der Schnittmenge *P* aller durch Drehung um einen Winkel α mit -α1 ≤ α ≤ α2 um die Drehachse aus dem Hohlraum des Magnetsystems generierter Körper innerhalb oder auf der Kontur befinden. Diese Ausführungsformen können im entsprechenden Abschnitt das größtmögliche Volumen zur Verfügung stellen. Ein solcher Messkopf ist in Fig. 3 im Schnitt entlang der *xz-*Ebene dargestellt. Hierbei sind Kontur K und die Begrenzung des Hohlraumes 4 als durchgezogene Linien dargestellt. Der Teil des Messkopfes, der sich außerhalb des Hohlraumes befindet ist gestrichelt dargestellt. Der Hohlraum stellt in diesem Fall keine durchgehende Bohrung dar.

Bei einer Klasse von vorteilhaften Ausführungsformen des erfindungsgemäßen Messkopfes ist die Kontur *K* des Messkopfes aus Abschnitten von Zylindermantelflächen und/oder Kugelflächen aufgebaut. Diese Formen können den Verstellweg maximieren und sind zugleich einfach herstellbar.

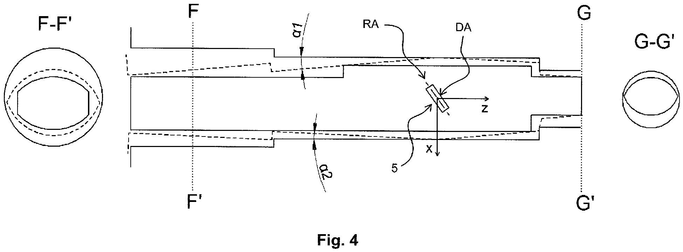

Eine weitere Klasse von besonders einfach aufgebauter und kompakter Ausführungsformen der Erfindung zeichnet sich dadurch aus, dass der Schnitt *S*(z) der Kontur *K* des Messkopfes mit einer zur *xy*-Ebene parallelen Ebene für mindestens einen *z*-Wert eine Form aufweist, die mindestens zwei Abschnitte enthält, welche zur *x*-Achse parallele Geraden sind. Dies hat den Vorteil, dass Raum neben dem Messkopf innerhalb des Hohlraums für andere Anwendungen frei verfügbar bleibt, z.B. zum Verlegen von Kabelleitungen oder optischen Fasern. Eine derartige Ausführungsform ist in Fig. 4 im Schnitt F-F' dargestellt.

Bevorzugt sind auch Ausführungsformen des erfindungsgemäßen NMR-MAS-Messkopfes, bei welchen für eine untere Breite *Q*u := *Q*(-*L*2), d.h. die Ausdehnung in der x-Richtung des Schnittes *S*(-*L*2) und/oder eine obere Breite *Q*o := Q(*L*1), d.h. die Ausdehnung in der *x*-Richtung des Schnittes *S*(*L*1) gilt:
*Q*u ≤ *Q*(*z*) ∀*z* > -*L*2 und ∃*z* für das gilt *Q*u < *Q*(*z*) und/oder
*Q*o ≤ *Q*(*z*) ∀*z* mit 0 < *z* < L1 und ∃*z* mit -*L*2 < *z* < *L*1 für das gilt *Q*o < *Q*(*z*) und/oder
*Q*u < *Q*(0) und *Q*o ≤ *Q*(0).

Dabei ist es besonders vorteilhaft, wenn *Q*u 20 %, besser 10 % kleiner als der *Q*(0). Es ist weiterhin besonders vorteilhaft, wenn Qu mindestens 20 %, besser 10 % bzw. 10 mm, besser 5 mm, idealerweise 3 mm kleiner ist als die Ausdehnung in *x*-Richtung des Schnittes von *P* mit der *xy*-Ebene. Dies ermöglicht einen besonders großen Verstellbereich des Winkels bei einem Drehpunkt in der Nähe des Nullpunktes.

Bei weiteren bevorzugten und in der Praxis bewährten Ausführungsformen gilt:
35 mm ≤ *Q*(0) ≤ 45 mm

Solche Messköpfe können in SB-Magnetsystemen betrieben werden, die mit deutlich höheren Feldstärken bei geringeren Kosten als WB- Systeme hergestellt werden können und in viel größerer Anzahl am Markt existieren. Gegenstand der Erfindung ist auch eine Anordnung gemäss Anspruch 10, welche einen erfindungsgemässen Messkopf sowie ein NMR-Magnetsystem umfasst. In diesem Fall umfasst der Verstellmechanismus ein Lager 8 innerhalb des Hohlraums des Magnetsystems. Bei besonders bevorzugten Weiterbildungen dieser Ausführungsform umfasst der Verstellmechanismus einen Mechanismus, der den Messkopf gegen das Lager 8 verspannt und/oder der Verstellmechanismus einen verstellbaren Abstandshalter am unteren Ende des Messkopfes beinhaltet.

Dadurch können Toleranzen durch Bewegungen des Messkopfes relativ zum Lager vermieden werden. Weiterhin ist es bevorzugt, wenn der Verstellmechanismus einen verstellbaren Abstandshalter am unteren Ende des Messkopfes beinhaltet, der dazu dient die Verkippung des Messkopfes gegenüber dem Magnetsystem zu definieren. Ein solcher Abstandshalter kann auch motorisiert ausgelegt werden um die Einstellung des Winkels zu automatisieren. Dies ist durch die reduzierten Anforderungen an die mechanische Präzision besonders einfach realisierbar. Außerdem kann sich der Motor außerhalb des Hohlraumes des Magnetsystems befinden, so dass die statischen Restfelder deutlich reduziert sind und die Möglichkeit besteht klassische Elektromotoren anstelle von Piezoantrieben einzusetzen.

Diese Ausführungsformen erlauben ein reproduzierbares Einführen des Messkopfes in das Magnetsystem und eine reproduzierbare Verstellung des Winkels. Insbesondere in Kombination mit einer Messung des Winkels erlaubt ein solcher Messkopf auch die Regelung bzw. Nachführung des Winkels bei thermischen Variationen.

Vorteilhaft ist auch eine Klasse von Weiterbildungen, bei welchen das Lager 8 ein im Magnetsystem integriertes Lagerstück 9 und einen zumindest teilweise kugelförmigen Abschluss des Messkopfes am oberen Ende oder einen zumindest teilweise zylinderförmigen Abschluss des Messkopfes am oberen Ende mit Zylinderachse parallel zur *y*-Achse umfasst. Ein solcher Messkopf ist in Fig.3 dargestellt.

Ein kugelförmiger Abschluss kann in einer Gegenkugel, einem Konus oder einer andersgestalteten Lagerung 9 aufgenommen werden und ein oberes Lager erzeugen. Besonders bevorzugt ist es, wenn der Mittelpunkt der Kugel im Nullpunkt des Koordinatensystems zu liegen kommt. In diesem Fall ist die Drehachse im Zentrum der Messprobe. Wird die Messprobe gegen diese Lagerung verspannt kann der Messkopfes im Magnetsystem reproduzierbar positioniert werden. Wird die Mechanik zur Winkelverstellung am unteren Ende des Messkopfes angebracht ist der Hebel so groß, dass keine mikrometrische Präzision zur Erreichung ausreichender Winkeltoleranzen und Reproduzierbarkeiten mehr notwendig ist. Dies reduziert die Kosten für die Winkelverstellung.

Andere Weiterbildungen beinhalten einen Abschluss in Form eines Zylinders mit Zylinderachse parallel zur *y*-Achse. Dadurch kann der Messkopf in einem passenden Gegenzylinder geführt werden, die Drehachse eindeutig definiert werden und eine Drehung des Messkopfes um eine Achse orthogonal zur Drehachse verhindert werden. Idealerweise stimmt die Zylinderachse des Abschlusses mit der *y*-Achse überein. Dies vereinfacht den Aufbau des Verstellmechanismus.

Eine Klasse von dazu alternativen Weiterbildungen zeichnet sich dadurch aus, dass das Lager durch eine mechanische Achse gebildet ist, die im Hohlraum des Magnetsystems gelagert ist und die Drehachse des Messkopfes darstellt. Die Gegenlagerung soll auch dann als Teil des Magnetsystems und nicht des Messkopfes verstanden werden, wenn sie fest mit dem Messkopf verbunden ist und im Betrieb lediglich im Magnetsystem eingeführt wird. Dies gilt insbesondere auch für Gegenlager für die zuvor erwähnten Kugel- oder Walzenlagerungen. Die Gegenlager dürfen außerhalb der der Schnittmenge aller durch Drehung um einen Winkel α mit -α1 ≤ α ≤ α2 um eine Drehachse aus dem Hohlraum des Magnetsystems generierter Körper liegen, da sie bei Drehung des Messkopfes starr bleiben. Auch eine Verbindung starrer und beweglicher Elemente des Messkopfes z.B. durch Balgen soll als Teil des Magnetsystems und nicht des Messkopfes bzw. der Kontur des Messkopfes im Hohlraum verstanden werden.

Besonders vorteilhaft ist es, wenn das untere Ende des Messkopfs mittels eines verstellbaren Abstandshalters gegenüber dem Magnetsystem verschoben werden kann. Die Kombination aus einer Linearbewegung und einem Drehpunkt nahe dem Ursprung des Koordinatensystems reduziert massiv die Toleranzanforderungen an den Verstellmechanismus. Dies reduziert die Kosten zur Herstellung des Gesamtsystems.

Vorzugsweise kann bei Weiterbildungen der oben beschriebenen Ausführungsformen der Verstellmechanismus eine unterhalb des Magnetsystems befestigte Wippe aufweisen. Besonders vorteilhaft ist es, wenn das untere Ende des Messkopfs mittels eines verstellbaren Abstandshalters gegenüber dem Magnetsystem verschoben werden kann. Die Kombination aus einer Linearbewegung und einem Drehpunkt nahe dem Ursprung des Koordinatensystems reduziert massiv die Toleranzanforderungen an den Verstellmechanismus. Dies reduziert die Kosten zur Herstellung des Gesamtsystems.

In den Rahmen der vorliegenden Erfindung fällt auch ein Verfahren zum Betrieb einer NMR -MAS Apparatur mit einem Messkopf der oben beschriebenen erfindungsgemäßen Art, welches sich dadurch auszeichnet, dass zur Einstellung des Winkels *θ* zwischen der Rotationsachse der Messprobe und dem homogenen statischen Magnetfeld ***B***₀ der im Hohlraum des Magnetsystems eingeführte Messkopf insgesamt, oder mindestens der sich im Hohlraum befindliche Teil des Messkopfes gegenüber der z-Achse um einen Winkel *θ* mit *θ*ₛₒₗₗ - α1 ≤ *θ* ≤ *θ*ₛₒₗₗ + α2 gedreht wird.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

Die Erfindung ist in der Zeichnung dargestellt und wird anhand von Ausführungsbeispielen näher erläutert. Es zeigen:
- Fig. 1: einen Schnitt *T* parallel zur *xz*-Ebene sowie zwei Schnitte *S* parallel zur yz-Ebene durch den Hohlraum 4 des Magnetsystems und der Schnittmenge *P* aller durch Drehung um einen Winkel α mit -α1 ≤ α ≤ α2 um die Drehachse aus dem Hohlraum des Magnetsystems generierter Körper;
- Fig. 2: eine Ausführungsform des erfindungsgemäßen Messkopfes mit abschnittsweise kreiszylinderförmiger Kontur, dargestellt in einem Schnitt *T* parallel zur *xz*-Ebene sowie in den Schnitten *S*(-L2) und *S*(0) parallel zur *yz*-Ebene;
- Fig. 3: eine Ausführungsform des erfindungsgemäßen Messkopfes, bei dem die Kontur *K* zumindest abschnittsweise für den Schnitt *T* mit der Begrenzungslinie der Schnittmenge *P* übereinstimmt;
- Fig. 4: eine Ausführungsform mit allgemeiner Formgebung des Hohlraumes und Verstellwinkeln α1 ≠ α2, bei der ein Schnitt *S* der Kontur *K* des Messkopfes mit einer Ebene parallel zur *xy*-Ebene für mindestens einen *z*-Wert eine Form aufweist, die mindestens zwei Abschnitte enthält, welche zur *x*-Achse parallele Geraden sind;
- Fig. 5: ein Magnetsystem gemäß Stand der Technik, bestehend aus einem Magneten und mindestens einem Shimsystem;
- Fig. 6: die Begrenzung des Hohlraumes und eine Messprobe mit ihrer Rotationsachse, sowie die *xyz-* und *x*'*y*'*z*'-Koordinatensysteme gemäß Stand der Technik;
- Fig. 7: die Bewegung einer Messprobe beim Verkippen mit Drehachse im Zentrum der Messprobe (links) sowie Drehachse außerhalb des Zentrums der Messprobe (rechts); und
- Fig. 8: ein Magnetsystem mit Messkopf gemäß Stand der Technik, bei dem die Einstellung des Winkels der Rotationsachse der Messprobe gegenüber der *z*-Achse mittels eines im Messkopf integrierten Mechanismus erfolgt.

Die Erfindung betrifft eine neuartige Ausgestaltung des Messkopfes in einem NMR-MAS-Spektrometer, bei welchem der Messkopf eine äußeren Kontur aufweist, die es erlaubt zumindest den im Hohlraum des Magnetsystems eingeführten Teil des Messkopfes gegenüber dem Magnetsystem im Bereich *θ*ₛₒₗₗ - α1 ≤ *θ* ≤ *θ*ₛₒₗₗ + α1 zu verkippen, sowie einen Verstellmechanismus, der die Position und den Winkel des Messkopfes gegenüber dem Magnetsystem definiert. Die Kontur weist dabei mindestens einen Schnitt parallel zur *xy*-Ebene auf, dessen Ausdehnung *Q*(*z*) kleiner ist als die Ausdehnung des Schnittes des Messkopfes mit der *xy*-Ebene *Q*(0).

Zunächst soll aber zum besseren Verständnis die bisher übliche Technik erläutert werden, die von der Erfindung nunmehr verbessert wird: MAS-Messköpfe beinhalten im Stand der Technik in der Regel einen Verstellmechanismus, der die präzise Einstellung des Winkels *θ* zwischen der Rotationsachse der Messprobe entlang *z'* und dem statischen Magnetfeld ***B***₀ entlang *z* im Bereich *θ*ₛₒₗₗ -α1 ≤ *θ* ≤ *θ*ₛₒₗₗ + α1 erlaubt. Ein solcher im Messkopf integrierter Verstellmechanismus wird als "interner" oder "integrierter" Mechanismus bezeichnet. Dabei wird in der Regel die Messprobe, der Stator, der die Lagerung und den Antrieb des Rotors beinhaltet und die HF-Spulen bewegt. Diese Bewegung wird durch Seilzüge, Spindeln und Zahnräder, Hebel mit Linearbewegungen oder ähnliche Mechanismen induziert und beinhaltet hauptsächlich eine Rotationsbewegung, im Allgemeinen aber auch Rotationsbewegungen kombiniert mit Linearbewegungen. Es sind Verstellmechanismen mit manueller und motorisierter Einstellung bekannt, insbesondere mit elektromotorischer Verstellung. Bei vielen Messköpfen im Stand der Technik, insbesondere solchen, die in SB-Magnetsystemen Anwendung finden kann die Verstellung des Winkels über einen sehr großen Bereich durchgeführt werden und dient auch zum leichteren Auswerfen der Messproben beim Probenwechsel.

Es ist bekannt, dass die Präzision dieser Verstellmechanismen insbesondere beim Wechsel der Probentemperatur häufig nicht ausreichend für anspruchsvolle NMR-Messungen ist. Dies gilt insbesondere für die Protonenspektroskopie und STMAS, bei denen Winkelfehler im Bereich einiger tausendstel Grad bereits zu merklichen Linienverbreiterungen in den gemessenen Spektren führen können. Ein weiteres Problem tritt bei Messköpfen mit kryogen gekühlten Detektionsspulen auf, bei denen die Spulen in der Regel durch ein Isolationsvakuum von den Messproben getrennt werden. Dazu befindet sich üblicherweise mindestens eine Wand eines Dewars zwischen den Detektionsspulen und der Messprobe. Es ist mechanisch sehr aufwändig eine Verkippung der Messproben, des Dewars und der RF-Spulen innerhalb eines Messkopfes zu integrieren, auch wenn dies in US 7,282,919 B2 für WB-Messköpfe so realisiert ist.

Im Stand der Technik wird folgendes Verfahren zur Einstellung des Winkels *θ* zwischen der Rotationsachse des Samples und der Magnetfeldrichtung verwendet: In der Regel wird eine Messprobe (z.B. pulverförmiges Kaliumbromid) mit möglichst großer Abhängigkeit der Linienbreite vom eingestellten Winkel mittels des NMR Messkopfs vermessen und die Linienbreiten der zentralen Linie und Rotationsseitenbanden und/oder die Höhe der Linien und/oder das Verhältnis der Amplitude/Breite zwischen verschiedenen Linien ausgewertet. Alternativ kann auch eine Auswertung direkt auf dem Zeitbereichssignal erfolgen. Die Verstellung des Winkels erfolgt in diesem Verfahren durch Betätigung einer Verstellmechanik, die den Stator relativ zur *z*-Achse um eine Drehachse herum verkippt. Da der Stator die Rotationsachse vorgibt wird hierdurch die Rotationsachse gegenüber der *z-*Achse um die Drehachse gedreht. Die Drehachse ist gegenüber dem Messkopf gelagert, der seine Position im Magnetsystem nicht verändert.

Messköpfe im Stand der Technik weisen in der Regel eine Kontur auf, die weitestgehend aus einem zylinderförmigen Rohr mit konstantem Außendurchmesser besteht. Häufig weisen diese Messköpfe auch Möglichkeiten zur Zentrierung und Positionierung gegenüber dem Magnetsystem auf (in der Regel im Bereich des oberen und unteren Ende des in den Hohlraum eingeführten Teils des Messkopfs), um beim Einbau des Messkopfes in das Magnetsystem eine möglichst eindeutig definierte Positionierung zu erreichen. Dadurch können die Messköpfe das maximal mögliche Volumen eines üblicherweise kreiszylinderförmigen Hohlraumes des Magnetsystems möglichst effizient ausnutzen.

Erfindungsgemäß werden die Probleme der MAS-Messköpfe im Stand der Technik dadurch gelöst, dass das NMR System so gestaltet ist, dass es einen Messkopf mit einer äußeren Kontur umfasst, die es erlaubt zumindest den im Hohlraum des Magnetsystems eingeführten Teil des Messkopfes gegenüber dem Magnetsystem zu verkippen bzw. zu verdrehen, sowie einen Verstellmechanismus, der die Position und den Winkel des Messkopfes gegenüber dem Magnetsystem definiert. Die Rotationsachse der Messprobe weist in einem erfindungsgemäßen Messkopf eine konstante Winkellage in Bezug auf den Messkopf auf, zumindest während der Einstellung des Winkels zwischen Rotationsachse und z-Achse. Die Kontur K des Messkopfes innerhalb des Hohlraums des Magnetsystems weist dabei mindestens einen Schnitt *S*(*z*1) parallel zur *xy*-Ebene auf mit *z*1 < 0, dessen Ausdehnung *Q*(*z*1) kleiner ist als die Ausdehnung des Schnittes des Messkopfes mit der *xy*-Ebene *Q*(0) und mindestens einen Schnitt *S*(*z*2) mit *z*2 > 0 mit einer Ausdehnung *Q*(*z*2) in der *x-*Richtung wobei *Q*(*z*2) ≤ *Q*(0).

Ein so gestalteter Messkopf kann bei vergleichbaren Dimensionen im Bereich der Messprobe über einen deutlich größeren Verstellbereich in Bezug auf das Magnetsystem verkippt werden als ein rohrförmiger Messkopf mit konstantem Durchmesser ohne integrierten Verstellmechanismus. Durch die Vergrößerung der Hebelverhältnisse beim Verkippen des Messkopfes in Bezug auf das Magnetsystem werden die Anforderungen an die mechanische Präzision deutlich reduziert. Außerdem ist es bedeutend einfacher die Temperatur des Außenmantels des Messkopfes sowie des im Magnetsystem enthaltenen Shimsystem beim Wechsel der Temperierung der Messproben konstant zu halten als die thermische Ausdehnung in einem integrierten Verstellmechanismus beim Wechsel der Temperatur der Messproben zu beherrschen. Dadurch erhöht sich die Präzision und Reproduzierbarkeit der eingestellten Winkel im Betrieb bei verschiedenen Messprobentemperaturen.

Weiterhin weist die Kontur *K* eines erfindungsgemäßen Messkopfes in der Regel mindestens einen Schnitt *S*(*z*3) parallel zur *xy*-Ebene auf, für den die Ausdehnung *R*(*z*3) in der *y*-Richtung größer oder gleich der Ausdehnung in der *x*-Richtung ist: *R*(*z*3) ≥ *Q*(*z*3). Besonders vorteilhaft ist es, wenn *R*(*z*) > *Q*(*z*) für ein großes Intervall von *z* < 0. Ein solcher Messkopf erlaubt es deutlich mehr Raum zur Verlegung von Gas, Vakuum oder elektrischen Leitungen sowie mechanischen Elemente zur Verfügung zu stellen als ein Messkopf mit kreiszylinderförmigen Querschnitten, der denselben Verstellbereich erlaubt.

Die Schnitte *S*(*z*) können dabei beliebige Formen aufweisen, wobei kreisförmige, ovale oder elliptische, aus einer Vielzahl von Kreisabschnitten zusammengesetzte, rechteckförmige (mit oder ohne abgerundete Kanten), oder aus Geraden und Kreisabschnitten zusammengesetzte Formen insbesondere von Vorteil sind, da sie einerseits viel Raum zur Verfügung stellen und andererseits leicht zu fertigen sind.

Auch ein Messkopf bei dem die Winkellage der Messprobe gegenüber dem Messkopf verändert werden kann, z.B. um die Messprobe in den Messkopf einzuführen bzw. auszuwerfen fällt unter den Rahmen der Erfindung, wenn die Winkellage der Rotationsachse in Bezug auf den Messkopf während des Einstellvorgangs des Winkels *θ* nicht verändert wird, sondern durch einen externen Verstellmechanismus realisiert wird. Die Präzisionsanforderungen an eine Verkippmechanik zum Auswerfen der Messproben ist Größenordnungen niedriger als die Anforderungen an einen Verstellmechanismus, so dass die Trennung der beiden Funktionalitäten sinnvoll ist.

Insbesondere für Messköpfe für SB-Magnetsysteme, die Wellenleiter für DNP-Messungen enthalten, bei denen die RF-Sende- und Empfangsspulen kryogen gekühlt sind sowie für Messköpfe für toxische oder gefährliche Substanzen ist eine externe Verstellung des Winkels vorzuziehen, da deutlich mehr freier Raum im Messkopf zur Verfügung steht um die Wellenleiter zu platzieren, Kühlleitungen, Strahlungsschilde, Wärmetauscher und Vakuumkomponenten zu integrieren bzw im letzten Fall um die für den Fall eines Rotorschadens kontaminierten Bereiche mit geringst möglicher Komplexität auszustatten um eine Reinigung zu vereinfachen bzw. den Schadensumfang zu begrenzen. Dies erlaubt es MAS-Messköpfe für SB-Magnetsysteme zu konzipieren, die bis Anhin im Stand der Technik lediglich für WB-Magnetsysteme zur Verfügung stehen. Dadurch werden deutlich geringere Anschaffungs- und Betriebskosten für die Nutzer dieser Technologien erzielt und ein größere Magnetfeldstärkenbereich verfügbar.

Die Abweichung der Außenkontur des Messkopfes von der im Stand der Technik bekannten Rohrform ist notwendig um einen externen Verstellmechanismus für Höchstfeld-Magnetsysteme mit statischem Feld *B*₀ > 20 T zur Verfügung stellen zu können, da diese Systeme einerseits lediglich als SB-Magnetsysteme existieren und andererseits sehr große Längen *L*2 im Bereich um einen Meter aufweisen. Ein Verkippen des Messkopfs ohne eine Reduktion der lateralen Dimensionen im Bereich negativer *z*-Werte würde keinen ausreichenden Verstellwinkelbereich erlauben um die Fertigungstoleranzen des Magnetsystems (Winkel der Magnetspule in Bezug auf den Magnetdewar, Montagetoleranzen des Shimsystems in Bezug auf den Magnetdewar) und der festen Winkellage der Rotationsachse in Bezug auf den Messkopf ausgleichen zu können und zugleich einen Rotor mit Lagerung und Antrieb in den Kopf integrieren zu können.

Der Verstellmechanismus des NMR-Systems kann folgendermaßen gestaltet sein:
Entweder der obere Abschluss des Messkopfs bildet zusammen mit einem Lagerstück innerhalb des Hohlraums des Magnetsystems ein Lager, der Messkopf enthält eine Achse, die im Magnetsystem gelagert ist oder ein Teil des Messkopfes wird flexibel ausgeführt, so dass er eine Kipp- bzw.
Drehbewegung des Messkopfes zulässt. Im Falle einer Lagerschale benötigt der Messkopf einen Mechanismus, der den Messkopf gegen diese Lagerschale verspannt bzw. ihn in der richtigen Höhe in Bezug auf die Lagerschale positioniert, so dass ein spielfreies Verstellen des Winkels ermöglicht wird. Die Winkelverstellung selbst kann durch einen Linearantrieb realisiert werden, der das untere Ende des Messkopfes weitestgehend parallel zur x-Achse relativ zum Magnetsystem verschiebt. Hierzu ist es notwendig, dass der Verstellmechanismus mechanisch an den Messkopf und das Magnetsystem gekoppelt ist.

Eine Alternative, bei der der vollständige Verstellmechanismus außerhalb des Hohlraumes zu liegen kommt beinhaltet eine Wippe, auf der der Messkopf befestigt wird und die sowohl die axiale Position des Messkopfes als auch den Winkel in Bezug auf das Magnetsystem bestimmt. Eine solche Wippe kann entweder mittels Achse und Hebeln, Spindeln, Zahnrädern, Linearantrieben oder Seilzügen verstellt werden. Alternativ kann die Wippe eine kugelförmige oder zylinderförmige Lagerung anstelle einer Achse umfassen.

Von Vorteil in Bezug auf den Stand der Technik ist die Vergrößerung der Dimensionen eines externen in Bezug auf einen in den Messkopf integrierten Verstellmechanismus, der zu einer Reduktion der erforderlichen mechanischen Präzision und Reproduzierbarkeit und somit reduzierten Herstellungs- und Wartungskosten führt.

Wird ein Sensor zur Detektion des eingestellten Winkels in den Messkopf integriert ist eine nicht integrierte Verstellmechanik ebenfalls von großem Vorteil, da der Sensor nicht auf ein kompaktes Bauteil montiert werden muss, dessen Temperatur sich nahe bei der Messprobentemperatur einstellt. Insbesondere Hall-Sensoren, die im Stand der Technik als Winkelsensoren bekannt sind (siehe z.B. US 8,203,339 B2), weisen eine sehr hohe Empfindlichkeit gegenüber Temperaturschwankungen auf, da die Ladungsträgerdichte und somit auch die Hallspannung eine starke Temperaturabhängigkeit aufweisen. Bei einem erfindungsgemäßen Messkopf kann ein solcher Hall-Sensor thermisch isoliert von der Messprobentemperatur im Messkopf montiert werden und dadurch mit deutlich höherer Präzision den Winkel bestimmen. Ähnliches gilt auch für die Bestimmung des Winkels mittels optischer Methoden.

### Liste der Bezugszeichen und Benennungen

- (1): Magnetspule
- (2): Raumtemperatur-Shimsystem
- (3): Dewar
- (4): Hohlraum
- (5): Messprobe
- (6): Wandung des Hohlraumes
- (7): gedrehte Messprobe
- (8): Lager
- (9): im Hohlraum integriertes Lagerstück
- (RA): Rotationsachse
- (DA): Drehachse
- *θ*: Winkel zwischen Rotationsachse und z-Achse
- *θ*ₘ: Magischer Winkel
- SB: Standard bore
- WB: Wide bore
- *D*_{B}: Durchmesser der Bohrung des Magnetsystems
- α: Verstellwinkel
- α1: maximaler negativer Verstellwinkel
- α2: maximaler positiver Verstellwinkel
- *M*: Menge von Raumpunkten, die den Hohlraum des Magnetsystems beschreiben
- *N*: Menge der Teilmengen *O*(α)
- *O*(α): durch Drehung mit α um die Drehachse aus der Menge *M* entstandene Körper
- *P*: Schnittmenge aller Teilmengen von *N*(∩*N*)
- *K*: Kontur des Messkopfes innerhalb des Hohlraumes
- *L*1: *z*-Position des oberen Endes des Messkopfes innerhalb des Hohlraumes
- *L2*: *z*-Position des unteren Endes des Hohlraumes
- *S*(*z*): Schnitt der Kontur *K* parallel zur *xy*-Ebene bei *z*
- *Q*(*z*): Ausdehnung des Schnittes *S*(*z*) in der *x*-Richtung
- *R*(*z*): Ausdehnung des Schnittes *S*(*z*) in der *y*-Richtung
- *T*: Schnitt der Kontur *K* mit der *xz*-Ebene

### Referenzliste

[1] US 7,498,812 B2
[2] US 2014/0099730 A1
[3] US 7,535,224 B2
[4] US-A 5,260,657
[5] US 7,282,919 B2
[6] US 8,547,099 B2
[7] US 8,203,339 B2
[8] "An X0 shim coil for precise magic-angle adjustment", T. Matsunagaa et al., J. Magn. Res., Vol. 256, 2015, p. 1-8
[9] "A Hall effect angle detector for solid-state NMR", S. Mamonea et al., J. Magn. Res., Vol. 190, 2008, p. 135-141
[10] "Optical lever for monitoring of the magic angle", E. Mihaliuk and T. Gullion, J. Magn. Res., Vol. 223, 2012, p. 46-50.

## Patentansprüche

1. Messkopf einer NMR-MAS-Apparatur, der im Betrieb zumindest zum Teil in einen Hohlraum (4) eines Magnetsystems eingeführt ist, das ein homogenes statisches Magnetfeld ***B***₀ in einer *z*-Richtung erzeugt,
wobei sich im Betrieb der NMR-MAS-Apparatur im Messkopf eine Messprobe (5) befindet, die eine Rotationsachse (RA) aufweist,
wobei die Rotationsachse (RA) in Bezug auf die *z*-Achse um einen Winkel *θ* > 0 geneigt ist, in einer *xz*-Ebene liegt, und wobei der Winkel *θ* durch eine mechanische Drehung um eine Drehachse (DA) parallel zur *y*-Achse im Intervall *θ*ₛₒₗₗ - α1 ≤ *θ* ≤ *θ*ₛₒₗₗ + α2 um einen Zielwinkel *θ*ₛₒₗₗ herum mit den Verstellwinkeln α1, α2 verstellt werden kann,
und wobei *z* = 0 als der Schnittpunkt der Rotationsachse (RA) mit der *z-*Achse bei eingestelltem Winkel *θ* = *θ*ₛₒₗₗ definiert ist,
**dadurch gekennzeichnet,**
**dass** die Rotationsachse (RA) gegenüber dem Messkopf eine unveränderliche feste Winkellage aufweist,
**dass** vorgesehen ist, mittels eines Verstellmechanismus der NMR-MAS-Apparatur zumindest den in den Hohlraum (4) eingeführten Teil des Messkopfs bei der mechanischen Drehung um die Drehachse (DA) um einen Winkel α mit -α1 ≤ α ≤ α2 gegenüber der z-Achse zu verstellen,
**dass** der Hohlraum (4) des Magnetsystems ein ausgedehnter Körper ist, der durch eine Menge *M* von Raumpunkten beschrieben wird, wobei eine Menge N aus allen Teilmengen *O*(α) besteht und die Teilmengen *O*(α) durch Drehung um den Winkel α mit -α1 ≤ α ≤ α2 um die Drehachse (DA) aus der Menge *M* entstandene Körper beschreiben,
**dass** eine Menge *P* = ∩*N* die Schnittmenge aller durch Drehung um einen Winkel α mit -α1 ≤ α ≤ α2 aus dem Hohlraum (4) des Magnetsystems generierter Körper ist,
**dass** der Messkopf eine äußere Kontur *K* hat, die ein oberes Ende bei *z* = L1 und ein unteres Ende bei *z* = -L2 aufweist und für die gilt, dass *K* eine Teilmenge von *P* ist: *K* ⊂ *P*, wobei für alle *z* mit -L2 ≤ *z* ≤ L1 ein Schnitt *S*(*z*) der Kontur *K* parallel zur *xy*-Ebene existiert, und wobei der Schnitt *S*(0) eine Ausdehnung *Q*(0) in der *x*-Richtung aufweist,
**dass** mindestens ein Schnitt *S*(*z*1) mit *z*1 < 0 existiert mit einer Ausdehnung *Q*(*z*1) in der *x*-Richtung, wobei *Q*(*z*1) < Q(0),
und **dass** mindestens ein Schnitt S(*z*2) mit *z*2 > 0 existiert mit einer Ausdehnung *Q*(*z*2) in der *x*-Richtung wobei *Q*(*z*2) ≤ *Q*(0).

2. Messkopf nach Anspruch 1, **dadurch gekennzeichnet, dass** der Winkel *θ*ₛₒₗₗ den Wert des magischen Winkels *θ*ₛₒₗₗ = arccos (3^{-0.5}) = *θ*ₘ in Bezug auf die *z-*Achse annimmt.

3. Messkopf nach einem der vorhergehenden Ansprüche, **dadurch gekennzeichnet, dass** die Kontur *K* des Messkopfes abschnittsweise Zylindermantelförmig, insbesondere abschnittsweise Kreiszylindermantelförmig ist.

4. Messkopf nach einem der vorhergehenden Ansprüche, **dadurch gekennzeichnet, dass** die Kontur des Messkopfes derart gestaltet ist, dass ein Schnitt *T* mit der *xz*-Ebene zumindest für einen Abschnitt eine Gerade unter dem Winkel +α1, -α1, +α2 oder -α2 aufweist.

5. Messkopf nach einem der vorhergehenden Ansprüche, **dadurch gekennzeichnet, dass** die Kontur *K* zumindest für einen Abschnitt identisch mit der Kontur der Schnittmenge *P* aller durch Drehung um einen Winkel α mit -α1 ≤ α ≤ α2 um die Drehachse (DA) aus dem Hohlraum (4) des Magnetsystems generierter Körper ist.

6. Messkopf nach einem der vorhergehenden Ansprüche, **dadurch gekennzeichnet, dass** die Kontur *K* des Messkopfes aus Abschnitten von Zylindermantelflächen und/oder Kugelflächen aufgebaut ist.

7. Messkopf nach einem der vorhergehenden Ansprüche, **dadurch gekennzeichnet, dass** der Schnitt der Kontur *K* des Messkopfes mit der *xy-*Ebene für mindestens einen *z*-Wert eine Form aufweist, die mindestens zwei Abschnitte enthält, welche zur *x*-Achse parallele Geraden sind.

8. Messkopf nach einem der vorhergehenden Ansprüche, **dadurch gekennzeichnet, dass** für eine untere Breite *Q*u := *Q*(-L2), d.h. die Ausdehnung in der *x*-Richtung des Schnittes *S*(-L2) und/oder eine obere Breite *Q*o := *Q*(L1), d.h. die Ausdehnung in der *x*-Richtung des Schnittes *S*(L1) gilt:
*Q*u ≤ *Q*(*z*) ∀*z* > -L2 und ∃*z* für das gilt *Q*u < *Q*(*z*) und/oder
*Q*o ≤ *Q*(*z*) ∀*z* mit 0 < *z* < L1 und ∃*z* mit -L2 < *z* < L1 für das gilt *Q*o < *Q*(*z*) und/oder
*Q*u < *Q*(0) und *Q*o ≤ *Q*(0)

9. Messkopf nach einem der vorhergehenden Ansprüche, **dadurch gekennzeichnet, dass** gilt: 35 mm ≤ *Q*(0) ≤ 45 mm.

10. Anordnung umfassend einen Messkopf nach einem der vorhergehenden Ansprüche sowie ein NMR-Magnetsystem mit einem Verstellmechanismus zur Drehung zumindest des in den Hohlraum eingeführten Teils des Messkopfs um den Winkel α gegenüber der z-Achse, wobei der Verstellmechanismus ein Lager (8) innerhalb des Hohlraumes (4) des Magnetsystems umfasst.

11. Anordnung nach Anspruch 10, **dadurch gekennzeichnet, dass** der Verstellmechanismus einen Mechanismus umfasst, der den Messkopf gegen das Lager (8) verspannt und/oder der Verstellmechanismus einen verstellbaren Abstandshalter am unteren Ende des Messkopfes beinhaltet.

12. Anordnung nach Anspruch 10 oder 11, **dadurch gekennzeichnet, dass** das Lager (8) ein im Magnetsystem integriertes Lagerstück (9) und einen zumindest teilweise kugelförmigen Abschluss des Messkopfes am oberen Ende oder einen zumindest teilweise zylinderförmigen Abschluss des Messkopfes am oberen Ende mit Zylinderachse parallel zur *y*-Achse umfasst.

13. Anordnung nach Anspruch 10 oder 11, **dadurch gekennzeichnet, dass** das Lager (8) durch eine mechanische Achse gebildet ist, die im Hohlraum (4) des Magnetsystems gelagert ist.

14. Anordnung nach einem der Ansprüche 10 bis 13, **dadurch gekennzeichnet, dass** der Verstellmechanismus eine unterhalb des Magnetsystems befestigte Wippe aufweist.

15. Verfahren zum Betrieb einer NMR -MAS Apparatur mit einem Messkopf beziehungsweise einer Anordnung nach einem der vorhergehenden Ansprüche, **dadurch gekennzeichnet, dass** zur Einstellung des Winkels *θ* zwischen der Rotationsachse (RA) der Messprobe (5) und dem homogenen statischen Magnetfeld *B*₀ zumindest der sich im Hohlraum (4) befindliche Teil des Messkopfes, gegenüber der z-Achse um einen Winkel *θ* mit *θ*ₛₒₗₗ - α1 ≤ *θ* ≤ *θ*ₛₒₗₗ + α2 gedreht wird.

## Claims

1. Probehead of an NMR-MAS apparatus, which is introduced during operation at least in part into a cavity (4) of a magnet system, which generates a homogeneous static magnetic field ***B***₀ in a *z*-direction,
wherein during operation of the NMR-MAS apparatus a measurement sample (5) is located in the probehead, which has a rotation axis (RA), wherein the rotation axis (RA) is tilted at an angle of *θ* > 0 in relation to the *z-*axis, lies in an *xz* plane, and wherein the angle *θ* can be adjusted by mechanical tilt around a tilt axis (DA) parallel to the y-axis in the interval *θ*_{target} - α1 ≤ *θ* ≤ *θ*_{target} + α2 around a target angle *θ*_{target} with the adjustment angles α1, α2,
and wherein *z* = 0 is defined as the point of intersection of the rotation axis (RA) with the *z*-axis at the adjusted angle *θ* = *θ*_{target},
**characterized in**
**that** the rotation axis (RA) has an unchangeable, fixed angular position relative to the probehead,
**that** it is provided to adjust at least the part of the probehead inserted into the cavity (4) by an angle α with -α1 ≤ α ≤ α2 relative to the *z*-axis, by mechanical rotation around the tilt axis (DA) by means of an adjustment mechanism of the NMR-MAS apparatus,
**that** the cavity (4) of the magnet system is an extended body, which is described by a set *M* of space points, wherein a set *N* consists of all subsets *O*(α) and the subsets O(α) are described by rotation around the angle α with -α1 ≤ α ≤ α2 around the tilt axis (DA) of the bodies arising from the set *M*, that a set *P* = ∩*N* is the intersection of all bodies generated by rotation by an angle α with -α1 ≤ α ≤ α2 of the cavity (4) of the magnet system,
**that** the probehead has an outer contour *K*, which has an upper end at *z* = L1 and a lower end at *z* = -L2 and for which it applies, that *K* is a subset of *P*: *K* c *P* , wherein for all *z* with -L2 ≤ *z* ≤ L1 an intersection S(*z*) of the contour *K* exists parallel to the *xy* plane, and wherein the intersection S(0) shows an extension *Q*(0) in the *x*-direction,
**that** at least one intersection S(*z*1) with *z*1 < 0 exists with an extension *Q*(z1) in the *x*-direction, wherein *Q*(*z*1) < *Q*(0),
and **that** at least one intersection S(*z*2) with *z*2 > 0 exists with an extension *Q*(*z*2) in the *x*-direction wherein *Q*(*z*2) ≤ *Q*(0).

2. Probehead according to claim 1, **characterized in that** the angle *θ*_{target} takes on the value of the magic angle *θ*_{target} = arccos (3^{-0.5}) = *θ*ₘ in relation to the *z-*axis.

3. Probehead according to one of the previous claims, **characterized in that** the contour *K* of the probehead is in sections the shape of a cylinder jacket, in particular in sections the shape of a circular cylinder jacket.

4. Probehead according to one of the previous claims, **characterized in that** the contour of the probehead is designed in such a way that an intersection *T* with the *xz*-plane shows a straight line under the angle +α1, -α1, +α2 or -α2 for at least one section.

5. Probehead according to one of the previous claims, **characterized in that** the contour *K* is identical to the contour of the intersection *P* for at least one section, for all bodies generated from the cavity (4) of the magnet system, by rotation at an angle α with -α1 ≤ α ≤ α2 around the tilt axis (DA).

6. Probehead according to one of the previous claims, **characterized in that** the contour *K* of the probehead is constructed from sections of cylinder jacket surfaces and/or spherical surfaces.

7. Probehead according to one of the previous claims, **characterized in that** the intersection of the contour *K* of the probehead with the xy-plane for at least one *z*-value shows a form, which contains at least two sections, which are straight lines parallel to the x-axis.

8. Probehead according to one of the previous claims, **characterized in that** for a lower width *Q*u: = *Q*(-L2), i.e. the extension in the *x*-direction of the intersection *S*(-L2) and/or an upper width *Q*o: = *Q*(L1), i.e. the extension in the *x*-direction of the intersection *S*(L1), the following applies:
*Q*u ≤ *Q*(*z*) ∀*z* > -L2 and ∃*z* for which *Q*u < *Q*(*z*) applies and/or
*Q*o ≤ *Q*(*z*) ∀*z* with 0 < *z* < L1 and ∃*z* with -L2 < *z* < L1 for which *Q*o < *Q*(*z*) applies and/or
*Q*u < *Q* (0) and *Q*o ≤ *Q*(0).

9. Probehead according to one of the previous claims, **characterized in that** the following applies: 35 mm ≤ *Q*(0) ≤ 45 mm.

10. Arrangement comprising a probehead according to one of the previous claims and an NMR magnet system comprising an adjustment mechanism for rotating at least that part of the probehead inserted into the cavity by the angle α relative to the z-axis, wherein the adjustment mechanism comprises a bearing (8) within the cavity (4) of the magnet system.

11. Arrangement according to claim 10, **characterized in that** the adjustment mechanism comprises a mechanism, which tensions the probehead against the bearing (8) and/or the adjustment mechanism contains an adjustable spacer at the lower end of the probehead.

12. Arrangement according to claim 10 or 11, **characterized in that** the bearing (8) comprises a bearing piece (9) integrated into the magnet system, and an at least partially spherical closure of the probehead at the upper end, or an at least partially cylindrical closure of the probehead at the upper end, with the cylinder axis parallel to the *y*-axis.

13. Arrangement according to claim 10 or 11, **characterized in that** the bearing (8) is formed by a mechanical axis, which is mounted in the cavity (4) of the magnet system.

14. Arrangement according to any one of the claims 10 to 13, **characterized in that** the adjustment mechanism comprises a rocker fastened underneath the magnet system.

15. Method for the operation of an NMR -MAS apparatus with a probehead or an arrangement according to one of the previous claims, **characterized in that** to adjust the angle *θ* between the rotation axis (RA) of the sample (5) and the homogeneous static magnetic field *B*_{0,} at least the part of the probehead located in the cavity (4) should be tilted relative to the *z*-axis at an angle of *θ* with *θ*_{target} - α1 ≤ *θ* ≤ *θ*_{target} + α2.

## Revendications

1. Tête de mesure d'un appareil de RMN MAS qui, pendant le fonctionnement, est introduite au moins en partie dans une cavité (4) d'un système magnétique qui génère un champ magnétique homogène statique *B*₀ dans une direction *z*,
dans laquelle tête de mesure se trouve, pendant le fonctionnement de l'appareil de RMN MAS, un échantillon de mesure (5) qui présente un axe de rotation (RA), dans laquelle l'axe de rotation (RA) est incliné d'un angle *θ* > 0 par rapport à l'axe *z* et situé dans un plan *xz*, et l'angle *θ* peut être réglé par une rotation mécanique autour d'un axe de rotation (DA) parallèle à l'axe *y* dans l'intervalle *θ*ₛₒₗₗ - α1 ≤ θ ≤ *θ*ₛₒₗₗ + α2 autour d'un angle cible *θ*ₛₒₗₗ avec les angles de réglage α1, α2,
et dans laquelle *z* = 0 est défini comme le point d'intersection de l'axe de rotation (RA) avec l'axe z lorsque l'angle *θ* = *θ*ₛₒₗₗ est réglé,
**caractérisée en ce**
**que** l'axe de rotation (RA) présente une position angulaire fixe invariable par rapport à la tête de mesure,
**qu'**il est prévu, au moyen d'un mécanisme de réglage de l'appareil de RMN MAS, de régler au moins la partie de la tête de mesure introduite dans la cavité (4), lors de la rotation mécanique autour de l'axe de rotation (DA), d'un angle α avec -al ≤ α ≤ α2 par rapport à l'axe *z*,
**que** la cavité (4) du système magnétique est un corps étendu qui est décrit par un ensemble *M* de points de l'espace, un ensemble *N* étant composé de tous les sous-ensembles *O*(α) et les sous-ensembles *O*(α) décrivant des corps obtenus à partir de l'ensemble *M* par rotation de l'angle α avec -α1 ≤ α ≤ α2 autour de l'axe de rotation (DA),
**qu'**un ensemble *P* = ∩*N* est l'intersection de tous les corps générés par rotation d'un angle α avec -α1 ≤ α ≤ α2 à partir de la cavité (4) du système magnétique, que la tête de mesure a un contour extérieur *K* qui présente une extrémité supérieure à *z* = L1 et une extrémité inférieure à *z* = -L2 et auquel s'applique que *K* est un sous-ensemble de *P* : *K* ⊂ *P*, sachant qu'il existe pour tous les *z* tels que - L2 ≤ z ≤ L1 une coupe *S*(*z*) du contour *K* parallèlement au plan *xy*, et que la coupe *S*(0) présente une extension *Q*(0) dans la direction *x*,
**qu'**il existe au moins une coupe *S*(*z*1) avec *z*1 < 0 ayant une extension *Q*(*z*1) dans la direction *x*, avec *Q*(*z*1) ≤ *Q*(0),
et **qu'**il existe au moins une coupe *S*(*z*2) avec *z*2 > 0 ayant une extension *Q*(*z*2) dans la direction *x*, avec *Q*(*z*2) ≤ *Q*(0)*.*

2. Tête de mesure selon la revendication 1, **caractérisée en ce que** l'angle *θ*ₛₒₗₗ prend la valeur de l'angle magique *θ*ₛₒₗₗ = arccos (3^{-0.5}) = *θ*ₘ par rapport à l'axe *z*.

3. Tête de mesure selon l'une des revendications précédentes, **caractérisée en ce que** le contour *K* de la tête de mesure est en forme d'enveloppe de cylindre sur certaines parties, en particulier en forme d'enveloppe de cylindre circulaire sur certaines parties.

4. Tête de mesure selon l'une des revendications précédentes, **caractérisée en ce que** le contour de la tête de mesure est conçu de telle sorte qu'une coupe *T* avec le plan *xz* présente, au moins pour une partie, une droite sous l'angle +α1, -α1, +α2 ou-α2.

5. Tête de mesure selon l'une des revendications précédentes, **caractérisée en ce que** le contour *K* est, au moins pour une partie, identique au contour de l'intersection *P* de tous les corps générés par rotation d'un angle α avec -α1 ≤ α ≤ α2 autour de l'axe de rotation (DA) à partir de la cavité (4) du système magnétique.

6. Tête de mesure selon l'une des revendications précédentes, **caractérisée en ce que** le contour *K* de la tête de mesure est constitué de parties de surfaces d'enveloppe de cylindre et/ou de surfaces sphériques.

7. Tête de mesure selon l'une des revendications précédentes, **caractérisée en ce que** la coupe du contour *K* de la tête de mesure avec le plan *xy* présente pour au moins une valeur *z* une forme qui contient au moins deux parties qui sont des droites parallèles à l'axe *x*.

8. Tête de mesure selon l'une des revendications précédentes, **caractérisée en ce que** pour une largeur inférieure *Q*u := *Q*(-L2), c'est-à-dire l'extension dans la direction *x* de la coupe *S*(-L2) et/ou une largeur supérieure *Q*o := *Q*(L1), c'est-à-dire l'extension dans la direction *x* de la coupe *S*(L1), il s'applique :
*Q*u ≤ *Q*(*z*) ∀z > - L2 et ∃*z* pour lequel *Q*u *< Q*(*z*) et/ou
*Qo* ≤ *Q*(*z*) ∀*z* avec 0 < *z* < L1 et ∃*z* avec -L2 < *z* < L1 pour lequel *Qo < Q*(*z*) et/ou
*Q*u < *Q*(0) et *Qo* ≤ *Q*(0).

9. Tête de mesure selon l'une des revendications précédentes, **caractérisée en ce que** 35 mm ≤ *Q*(0) ≤ 45 mm.

10. Ensemble comprenant une tête de mesure selon l'une des revendications précédentes ainsi qu'un système magnétique de RMN comprenant un mécanisme de réglage pour faire tourner au moins la partie de la tête de mesure introduite dans la cavité de l'angle α par rapport à l'axe *z*, dans lequel le mécanisme de réglage comprend un palier (8) à l'intérieur de la cavité (4) du système magnétique.

11. Ensemble selon la revendication 10, **caractérisé en ce que** le mécanisme de réglage comprend un mécanisme qui met la tête de mesure en tension contre le palier (8) et/ou le mécanisme de réglage comprend une entretoise réglable à l'extrémité inférieure de la tête de mesure.

12. Ensemble selon la revendication 10 ou 11, **caractérisé en ce que** le palier (8) comprend une pièce de palier (9) intégrée dans le système magnétique et une terminaison au moins partiellement sphérique de la tête de mesure à l'extrémité supérieure ou une terminaison au moins partiellement cylindrique de la tête de mesure à l'extrémité supérieure, avec un axe de cylindre parallèle à l'axe *y*.

13. Ensemble selon la revendication 10 ou 11, **caractérisé en ce que** le palier (8) est formé par un axe mécanique qui est monté dans la cavité (4) du système magnétique.

14. Ensemble selon l'une des revendications 10 à 13, **caractérisé en ce que** le mécanisme de réglage présente une bascule fixée au-dessous du système magnétique.

15. Procédé de fonctionnement d'un appareil de RMN MAS comprenant une tête de mesure, respectivement un ensemble, selon l'une des revendications précédentes, **caractérisé en ce que** pour régler l'angle *θ* entre l'axe de rotation (RA) de l'échantillon de mesure (5) et le champ magnétique homogène statique *B*₀, on fait tourner au moins la partie de la tête de mesure se trouvant dans la cavité (4) d'un angle *θ*, avec *θ*ₛₒₗₗ - α1 ≤ *θ* ≤ *θ*ₛₒₗₗ + α2, par rapport à l'axe *z*.
